# EUROPÄISCHE PATENTANMELDUNG

(11) **EP 1 180 796 A2**
(43) Veröffentlichungstag der Anmeldung: **20.02.2002**
(21) Anmeldenummer: 01118293.8
(22) Anmeldetag: 31.07.2001
(51) Int. Cl.: H01L 21/8242, H01L 21/02

(54) **Grabenkondensator und Verfahren zu seiner Herstellung**

(30) Priorität: 18.08.2000 DE 10040464
(71) Anmelder: Infineon Technologies AG, 81669 München (DE)
(72) Erfinder: Lützen, Jörn, 01099 Dresden (DE); Morgenschweis, Anja, 01108 Dresden (DE); Gutsche, Martin, 84405 Dorfen (DE); Förster, Matthias, 01099 Dresden (DE)
(74) Vertreter: Patentanwaltskanzlei WILHELM & BECK

(57) **Zusammenfassung**

Ein Graben-Kondensator, insbesondere zur Verwendung in einer Halbleiter-Speicherzelle weist eine Schichtenfolge auf, die aus einer im wesentlichen blockförmigen inneren Elektrodenschicht, einer dielektrischen Zwischenschicht und einer im Silizium-Substrat ausgebildeten äußeren Elektrodenschicht besteht, wobei zwischen der dielektrischen Zwischenschicht und der äußeren Elektrodenschicht und/oder der inneren Elektrodenschicht eine aufgerauhte Silizium-Schicht aus Silizium-Körnern vorzugsweise mit einem Durchmesser von im wesentlichen 10 bis 100nm vorgesehen ist, um die Oberfläche der Elektroden zu vergrößern.

## Beschreibung

Die vorliegende Erfindung betrifft ein Verfahren zu seiner Herstellung eines Grabenkondensator gemäß dem Oberbegriff des Anspruchs 1.

In integrierten Schaltungen (ICs) werden im allgemeinen Kondensatoren zur Ladungsspeicherung verwendet. So setzen sich die dynamischen Schreib/Lesespeicher (DRAMs) von Speicher-ICs jeweils aus einem Auswahl-Transistor und einem Speicher-Kondensator zusammen, wobei die Information im Speicher-Kondensator in Form von elektrischen Ladungen gespeichert wird. Ein Speicher-IC besteht aus einer Matrix von solchen DRAM-Zellen, welche in Form von Zeilen und Spalten verschaltet sind. Üblicherweise werden die Zeilenverbindungen als Wortleitungen und die Spaltenverbindungen als Bitleitungen bezeichnet. Der Auswahl-Transistor und der Speicher-Kondensator in der DRAM-Zelle sind dabei so miteinander verbunden, dass bei Ansteuerung des Auswahl-Transistors über eine Wortleitung die Ladung des Speicher-Kondensators über eine Bitleitung ein- und ausgelesen werden kann.

Ein Schwerpunkt bei der Technologieentwicklung von Speicher-ICs mit DRAMs ist der Speicher-Kondensator. Um ein ausreichendes Lesesignal von diesem Speicher-Kondensator zu erhalten, ist es erforderlich, dass die Speicherkapazität ca. 25-40fF beträgt. Um für eine solche Speicherkapazität bei der von Technologieschritt zu Technologieschritt ständig abnehmenden Zellenfläche für die DRAMs zu sorgen, wurden deshalb Speicher-Kondensatoren entwickelt, die die dritte Dimension nutzen. Solche dreidimensionalen Speicher-Kondensatoren werden bei DRAM-Zellen zum Beispiel als Graben-Kondensatoren ausgeführt, die so hergestellt werden, dass ein Graben in das Halbleitersubstrat geätzt wird, der mit einer dielektrischen Schicht und einer ersten Speicherelektrode ausgefüllt wird, wobei das Halbleitersubstrat als zweite Speicherelektrode dient. Der Auswahl-Transistor der DRAM-Zellen wird dann üblicherweise auf der planaren Halbleiteroberfläche neben dem Graben-Kondensator ausgebildet.

Aufgrund der weiterhin zunehmenden Verkleinerung der DRAM-Zellen wird auch bei den Graben-Kondensatoren nach Wegen gesucht, bei abnehmendem Grabendurchmesser wegen verkleinerter Zellenfläche eine gleichbleibende Kondensator-Kapazität zu gewährleisten. Eine Möglichkeit hierbei ist die Tiefe der Gräben zu erhöhen, wobei dieses Vorgehen jedoch inzwischen sowohl an technologische als auch wirtschaftliche Grenzen stößt. Zum einen erfordert das Erzeugen zunehmend tieferer Gräben bei gleichzeitig verkleinertem Grabendurchmesser Ätzverfahren, die sehr hohe Aspektverhältnisse (Verhältnis von Spaltentiefe zur Spaltenbreite) erreichen. Beim Aspektverhältnis sind jedoch den bekannten Ätzverfahren Grenzen gesetzt. Weiterhin erfordert die Grabenätzung ab einer bestimmten Tiefe eine stark verlängerte Ätzzeit, was die Kosten des Ätzprozesses wesentlich erhöht.

Alternativ und zusätzlich zu einer weiteren Vertiefung der Gräben kommen deshalb verstärkt Verfahren zum Einsatz, die es erlauben, die Oberfläche innerhalb des Graben-Kondensators zu vergrößern, um hierdurch für eine ausreichende Speicherkapazität zu sorgen. So sind Verfahren bekannt, bei denen der Graben-Kondensator in seinem unteren Bereich durch einen zusätzlichen Ätzschritt ausgeweitet wird, wodurch sich die Kondensatorfläche vergrößern lässt. Die für solche Ausweitung der Gräben erforderlichen Ätzprozesse stoßen jedoch ebenfalls an technologische Grenzen.

Neben den Graben-Kondensatoren werden auch Stapel-Kondensatoren zu einer dreidimensionalen Ausbildung von Speicher-Kondensatoren in Speicher-ICs eingesetzt. Ein Stapel-Kondensator besteht prinzipiell aus zwei übereinander angeordneten leitenden Schichten, die durch eine dielektrische Schicht getrennt sind. Stapel-Kondensatoren werden in DRAM-Zellen im allgemeinen oberhalb der planaren Auswahl-Transistoren ausgebildet, wobei eine der beiden Kondensator-Elektroden in elektrischer Verbindung mit dem Auswahl-Transistor steht. Um eine möglichst große Kondensatorfläche bei solchen Stapel-Kondensatoren zu erreichen und damit für eine ausreichende Speicherkapazität zu sorgen, wird die dielektrische Schicht zwischen den beiden leitenden Kondensator-Schichten vorzugsweise gefaltet ausgeführt. Solche Stapel-Kondensatoren sind unter der Bezeichnung Kronen-Stapel-Kondensatoren bekannt.

Weiterhin werden bei Stapel-Kondensatoren auch Verfahren eingesetzt, bei denen die Oberfläche der leitenden Kondensator-Schichten aufgerauht und hierdurch vergrößert wird. Insbesondere wird dabei zur Oberflächenvergrößerung rauhes Poly-Silizium, sogenanntes Hemispherical-Grain-Silizium HSG, eingesetzt, bei dem mit Hilfe einer speziellen Abscheidetechnik bzw. einer Temperaturbehandlung ca. 10 bis 100 nm große Silizium-Körner erzeugt werden. Da der HSG-Prozess technologisch jedoch nur sehr schwer beherrschbar ist, wird dieses Verfahren zur Oberflächenvergrößerung der Kondensatorelektroden und damit zur Erhöhung der Gesamtkapazität des Kondensators bisher ausschließlich bei Stapel-Kondensatoren eingesetzt. Verfahren zur Herstellung von HSG-Schichten bei Stapel-Kondensatoren sind unter anderem aus der US 5 723 379, der US 5 858 852 und der US 5 858 837 bekannt.

Aus der US 5 877 061 ist weiterhin ein Graben-Kondensator bekannt, bei dem eine verbesserte Kondensator-Kapazität durch eine aufgerauhte Oberfläche im Bereich der Kondensator-Elektroden erreicht wird. Hierzu wird eine körnige Poly-Silizium-Schicht oder eine HSG-Silizium-Schicht in dem Bereich, in dem die Kondensator-Elektroden im Graben ausgebildet werden sollen, abgeschieden und anschließend isotrop abgeätzt, so dass eine aufgerauhte Silizium-Oberfläche im Kondensator-Elektroden-Bereich zurückbleibt. Diese Technik zur Kapazitätsvergrößerung im Graben-Kondensator ist jedoch aufwendig, da zusätzliche Ätzprozesse vorgesehen sind. Darüber hinaus besteht die Gefahr, dass die körnige Poly-Silizium-Schicht bzw. die HSG-Silizium-Schicht insbesondere im Kragenbereich, der zur Isolierung der Kondensator-Elektroden dient, nicht vollständig abgeätzt wird, wodurch Leckstrompfade entstehen können.

Bei geringer oder gar nicht vorhandener Ätzselektivität zur Ätzmaske, haben isotrope Ätzungen darüber hinaus die Tendenz, ursprünglich vorhandene Rauhigkeiten auszugleichen, wodurch die zunächst im HSG vorhandene Rauhigkeit nur unvollständig in das darunterliegende Silizium übertragen werden kann.

Es wäre jedoch auch wünschenswert, wenn bei Graben-Kondensatoren die Möglichkeit bestände, durch rauhe Oberflächen nach dem HSG-Verfahren vergrößerte Kondensatorenoberflächen und damit eine erhöhte Speicherkapazität zu erzielen. Eine Verwendung von HSG-Silizium in Graben-Kondensatoren ist jedoch insbesondere deshalb nicht gelungen, weil die bekannten Verfahren es nicht erlauben, das HSG-Silizium auf die Bereiche im Graben-Kondensator zu beschränken, die als Elektrodenoberfläche dienen. Üblicherweise wird bei Graben-Kondensatoren im Bereich des Grabens ein dielektrischer Kragen erzeugt, um die Entstehung eines parasitären vertikalen Feldeffekt-Transistors zu verhindern. Beim Einsatz von HSG-Silizium zur Vergrößerung der Elektrodenoberfläche besteht jedoch die Gefahr, dass insbesondere auch in diesem Kragenbereich HSG-Silizium zurück bleibt, was dann zu unerwünschten Leckströmen führen kann.

Aus der EP 980 100 A2 ist ein gattungsbildendes Verfahren bekannt. Bei diesem bekannten Verfahren zur Herstellung eines Grabenkondensators erfolgt eine Erzeugung einer HSG-Silizium-Schicht zuerst auf der gesamten Grabenoberfläche. Anschließend wird der untere Bereich der HSG-Silizium-Schicht maskiert und dann die HSG-Silizium-Schicht im oberen Bereich in eine Oxidschicht umgewandelt, wobei ein unterer Teil dieser Oxidschicht dann erweitert und als Isolationskragen eingesetzt wird.

Aufgabe der vorliegenden Erfindung ist es einfaches und zuverlässiges Verfahren zur Erzeugung einer HSG-Silizium-Schicht in einen Graben-Kondensator zu schaffen, wobei die HSG-Silizium-Schicht ausschließlich auf den Bereich der Elektrodenoberflächen begrenzt ist.

Diese Aufgabe wird durch das in Anspruch 1 oder 2 angegebene Herstellungsverfahren gelöst. Bevorzugte Ausgestaltungen sind in den abhängigen Ansprüchen angegeben.

Gemäß einer ersten Variante der Erfindung wird eine selektive Erzeugung einer aufgerauhten Silizium-Schicht im unteren Grabenbereich vorgenommen, wobei amorphes, nicht aufgerauhtes Silizium auf der Grabenoberfläche abgeschieden und dann strukturiert wird, wodurch die amorphe Silizium-Schicht, aus der anschließend die Silizium-Körner erzeugt werden, nur im unteren Grabenbereich, in dem die Kondensatorelektroden ausgebildet werden, verbleibt. Diese Ausgestaltung ermöglicht es auf besonders einfache Weise die aufgerauhte Silizium-Schicht nur im Bereich der Elektrodenoberflächen zu erzeugen.

Gemäß einer zweiten Variante der Erfindung erfolgt eine Erzeugung einer aufgerauhten Silizium-Schicht zuerst auf der gesamten Grabenoberfläche, wobei anschließend der untere Bereich dieser aufgerauhten Silizium-Schicht maskiert und dann die aufgerauhte Silizium-Schicht im oberen Bereich mit Hilfe eines Ätzverfahrens entfernt wird. Zur Entfernung der aufgerauhten Silizium-Schicht im oberen Grabenbereich wird dabei vorzugsweise zuerst eine Planarisierung der vorher erzeugten Silizium-Körner unter geeigneten Prozessbedingungen durchgeführt, wobei die aufgerauhte Silizium-Schicht im unteren Grabenbereich vorzugsweise durch eine temperaturstabile Schicht geschützt ist.

Durch den erfindungsgemäßen Prozessablauf wird gewährleistet, dass die aufgerauhte Silizium-Schicht im IsolationskragenBereich zuverlässig entfernt wird und durch die Maskierung im unteren Bereich gleichzeitig verhindert wird, dass dieser aufgerauhte Silizium-Schichtbereich bei der Strukturierung beschädigt wird. Durch die den zusätzlich möglichen Planarisierungsschritt wird dabei ein besonders einfaches Entfernen bzw. Verändern der aufgerauhten Silizium-Schicht im oberen Grabenbereich ermöglicht.

Mit Hilfe der Erfindung ist es so möglich, einen Graben-Kondensator zu erzeugen, bei dem die Oberfläche der Kondensator-elektroden durch die aufgerauhte Silizium-Oberfläche stark vergrößert ist, wodurch die Kapazität des Graben-Kondensators erhöht wird und gleichzeitig gewährleistet ist, dass die aufgerauhte Silizium-Schicht nur auf der Elektrodenoberfläche innerhalb des Grabens ausgebildet wird. Durch diesen Aufbau wird sichergestellt, dass kein Leckstrom zwischen den Elektroden des Graben-Kondensators fließt, der zu einem schnellen Verlust der Speicherladung im Graben-Kondensator führen würde. Gleichzeitig wird durch die Beschränkung der aufgerauhten Silizium-Schicht auf die Elektrodenoberfläche verhindert, dass eine unzulässige Einengung des oberen Grabenabschnitts, der zur Kontaktierung des Auswahl-Transistors erforderlich ist, auftritt.

Um einen Graben-Kondensator herzustellen, wird gemäß einer bevorzugten Ausführungsform nach einem Ausbilden einer dotierten Schicht im Silizium-Substrat im unteren Bereich des Grabens entweder eine Isolationsschicht im oberen Bereich des Grabens zum Ausbilden des Isolationskragens und dann die aufgerauhte Silizium-Schicht im unteren Bereich des Grabens erzeugt oder nach Ausbilden der dotierten Schicht im Silizium-Substrat im unteren Bereich des Grabens erst die aufgerauhte Silizium-Schicht in diesen Bereich erzeugt und dann im oberen Bereich die Isolationsschicht für den Isolationskragen ausgebildet.

Die Erfindung wird anhand der beigefügten Zeichnungen näher erläutert.

### In den Zeichnungen zeigen:

Figur 1 eine erste Ausführungsform eines erfindungsgemäßen Verfahrens zur Herstellung eines Graben-Kondensators mit einer nicht-selektiven HSG-Silizium-Erzeugung vor der Kragenausbildung;
Figur 2 eine zweite Ausführungsform eines erfindungsgemäßen Verfahrens zur Herstellung eines Graben-Kondensators mit einer nicht-selektiven HSG-Silizium-Erzeugung nach Ausbildung des Isolationskragens;
Figur 3 eine dritte Ausführungsform eines erfindungsgemäßen Verfahrens zur Herstellung eines Graben-Kondensators mit einer nicht-selektiven HSG-Silizium-Erzeugung nach Ausbildung des Isolationskragens;
Figur 4 eine vierte Ausführungsform eines erfindungsgemäßen Verfahrens zum Herstellen eines Graben-Kondensators mit einer nicht-selektiven HSG-Silizium-Erzeugung nach Ausbildung des Isolationskragens;
Figur 5 eine fünfte Ausführungsform eines erfindungsgemäßen Verfahrens zur Herstellung eines Graben-Kondensators mit einer selektiven HSG-Silizium-Erzeugung nach Ausbildung eines Isolationskragens;
Figur 6 ein Schaltbild einer DRAM-Zelle; und
Figur 7 einen schematischen Querschnitt durch eine DRAM-Zelle mit einem Graben-Kondensator.

Die Erfindung wird anhand der Herstellung von Graben-Kondensatoren im Rahmen einer Prozessfolge zum Ausbilden von DRAM-Speicherzellen auf Siliziumbasis erläutert. Die erfindungsgemäßen Graben-Kondensatoren können jedoch auch in anderen hochintegrierten Schaltungen, bei denen Kondensatoren benötigt werden, eingesetzt werden. Die Ausbildung der Graben-Kondensatoren erfolgt vorzugsweise in der Silizium-Planartechnik, die aus Abfolgen von jeweils ganzflächig an der Scheibenoberfläche wirkenden Einzelprozessen besteht, wobei über geeignete Markierungsschichten gezielt eine lokale Veränderung des Silizium-Substrats durchgeführt wird. Bei der DRAM-Herstellung werden dabei gleichzeitig eine Vielzahl von Zellen mit den entsprechenden Graben-Kondensatoren ausgebildet. Im Folgenden wird die Erfindung jedoch nur hinsichtlich der Ausbildung eines einzelnen Graben-Kondensators beschrieben.

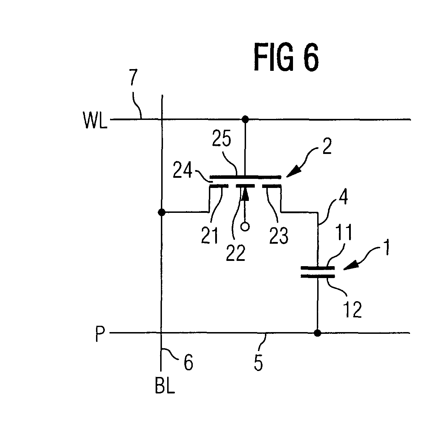

In DRAM-Speichern werden vorwiegend 1-Transistor-Zellen eingesetzt, deren Schaltbild in Figur 6 gezeigt ist. Diese 1-Transistor-Zellen bestehen aus einem Speicher-Kondensator 1 und einem Auswahl-Transistor 2. Der Auswahl-Transistor 2 ist dabei vorzugsweise als Feldeffekttransistor ausgelegt und weist eine stromliefernde Source-Elektrode 21 und eine stromaufnehmende Drain-Elektrode 23 auf, zwischen denen ein aktiver Bereich 22 angeordnet ist, in dem ein stromleitender Kanal zwischen der Source-Elektrode 21 und der Drain-Elektrode 23 ausgebildet werden kann. Über dem aktiven Bereich 22 ist eine Isolatorschicht 24 und eine Gate-Elektrode 25 angeordnet, die wie ein Platten-Kondensator wirken, mit dem die Ladungsdichte im aktiven Bereich 22 beeinflusst werden kann.

Die Drain-Elektrode 23 des Feldeffekttransistors 2 ist über eine Verbindungsleitung 4 mit einer ersten Elektrode 11 des Speicher-Kondensators 1 verbunden. Eine zweite Elektrode 12 des Speicher-Kondensators 1 wiederum ist an einer Kondensatorplatte 5 angeschlossen, die vorzugsweise allen Speicher-Kondensatoren der DRAM-Zellenanordnung gemeinsam ist. Die Source-Elektrode 21 des Feldeffekttransistors 2 ist mit einer Bitleitung 6 verbunden, um die im Speicher-Kondensator 1 in Form von Ladungen gespeicherte Informationen ein- und auslesen zu können. Der Ein- und Auslesevorgang wird dabei über eine Wortleitung 7 gesteuert, die an die Gate-Elektrode 25 des Feldeffekttransistors 2 angeschlossen ist, um durch Anlegen einer Spannung einen stromleitenden Kanal im aktiven Bereich 22 zwischen der Source-Elektrode 21 und der Drain-Elektrode 23 herzustellen.

Als Kondensator 1 wird bei DRAMs in vielen Fällen ein Graben-Kondensator eingesetzt, da durch die dreidimensionale Struktur eine wesentliche Verkleinerung der DRAM-Zellenfläche erreicht werden kann. Mit zunehmender Miniaturisierung der DRAM-Zellen und damit immer kleiner werdenden Querschnitten des Graben-Kondensators sind zusätzliche Maßnahmen erforderlich, um für eine ausreichende Kondensatorkapazität von ca. 25-40fF zu sorgen, die nötig ist, um ein ausreichend großes Lesesignal des DRAMs zu erhalten.

Eine Möglichkeit die Kapazität bei Graben-Kondensatoren zu erhöhen, besteht darin, tiefere Gräben zu erzeugen. Hier sind jedoch den dafür erforderlichen Ätzverfahren sowohl technologische als auch wirtschaftliche Grenzen gesetzt. Alternativ bietet sich deshalb die Möglichkeit an, die Kondensator-Kapazität durch Vergrößern der Oberfläche innerhalb des Graben-Kondensators zu erhöhen. Dabei werden insbesondere Techniken eingesetzt, die den unteren Bereich des Graben-Kondensators mit den Kondensator-Elektroden ausweiten, um so größere Elektrodenoberflächen zu erzeugen. Auch mit einer solchen Aufweitung der unteren Grabenbereiche kann aber aufgrund der zur Verfügung stehenden Zellenbereiche und der notwendigen Ätzverfahren nur eine beschränkte Kapazitätserweiterung erreicht werden. Gemäß der Erfindung wird deshalb die Oberfläche der Kondensatorelektroden durch eine Silizium-Schicht mit Silizium-Körner, die einen Durchmesser von im wesentlichen 10 bis 100 nm besitzen, aufgerauht und damit zusätzlich vergrößert. Eine solche als HSG-Silizium bekannte Silizium-Schicht wird dabei vorzugsweise auf die Elektrodenoberflächen beschränkt, um Leckstrompfade zwischen den Elektroden des Graben-Kondensators zu verhindern. Geringe HSG-Reste sind jedoch im unteren Kragenbereich eventuell tolerierbar.

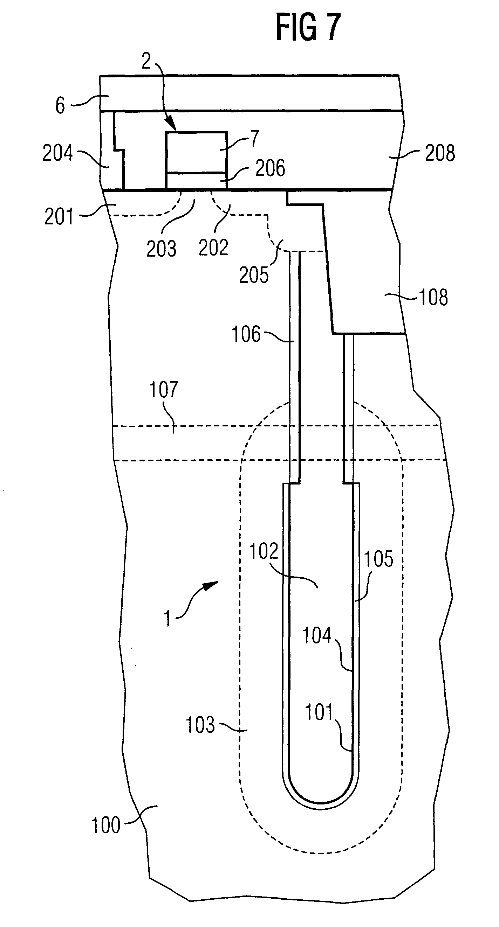

Figur 7 zeigt eine mögliche Ausführungsform eines erfihdungsgemäßen Graben-Kondensators in einer DRAM-Speicherzelle im Querschnitt. Der Graben-Kondensator 1 ist dabei in einem vorzugsweise einkristallinen Silizium-Substrat 100 ausbildet. Das Substrat ist vorzugsweise schwach p (p⁻) z. B. mit Bor (B) dotiert. Ein im Silizium-Substrat 100 ausgeführter Graben 101 ist vorzugsweise mit Poly-Silizium 102 ausgefüllt, das z. B. mit Arsen (As) oder Phosphor (P) hoch n (n⁺) dotiert ist. Dieses Poly-Silizium 102 bildet die innere Elektrode des Graben-Kondensators 1.

Im Silizium-Substrat 100 ist im unteren Bereich des Grabens 101 um diesen Graben herum eine n⁺-dotierte Schicht 103 ausgebildet, welche beispielsweise mit As dotiert ist. Diese n⁺-dotierte Schicht 103, im weiteren auch als vergrabene Platte bezeichnet, dient als äußere Elektrode des Graben-Kondensators 1. Zwischen den beiden Elektroden des Graben-Kondensators 1 ist ein Speicher-Dielektrikum 104 angeordnet, das die Kondensatorelektroden trennt. Das Speicher-Dielektrikum 104 kann dabei aus einem Stapel von dielektrischen Schichten, z. B. Oxid, nitrides Oxid oder Oxid-Nitrid-Oxid bestehen. Zwischen dem Speicher-Dielektrikum 104 und der vergrabenen Platte 103 ist weiterhin eine HSG-Silizium-Schicht 105 ausgebildet. Mit dieser HSG-Silizium-Schicht 105 kann die Oberfläche der vergrabenen Platte 103, die als äußere Elektrode des Graben-Kondensators 1 dient, um 25% bis deutlich über 100% im Vergleich zu einer planen Oberfläche abhängig von der Korngröße der HSG-Schicht vergrößert und somit im entsprechenden Umfang auch die Kondensator-Kapazität erhöht werden. In der gezeigten Ausführungsform ist die HSG-Silizium-Schicht zwischen dem Speicher-Dielektrikum 104 und der vergrabenen Platte 103 angeordnet.

Die HSG-Silizium-Schicht 105 ist vorzugsweise ähnlich wie die vergrabene Platte 103 n⁺-dotiert, um zu verhindern, dass eine Verarmungszone im Bereich der HSG-Silizium-Schicht auftritt, die zu einer Verminderung der Kapazität des Graben-Kondensators 1 führen würde. Eine solche Dotierung kann erreicht werden, indem eine Rückdiffusion von Dotieratomen aus der vergrabenen Platte 103 erfolgt, eine Dotierung der HSG-Schicht beim Abscheiden durchgeführt wird oder die HSG-Schicht nach dem Abscheiden nachdotiert wird.

Der Auswahl-Transistor 2 der DRAM-Zelle in der in Figur 7 gezeigten Ausführungsform weist zwei Diffusionsbereiche 201, 202 auf, die durch Implantieren von Dotieratomen im Silizium-Substrat 100 erzeugt und durch einen Kanal 203 getrennt werden. Der erste Diffusionsbereich 201 ist über einen Kontakt 204 mit der Bitleitung 6 verbunden. Der zweite Diffusionsbereich 202 ist über eine Kondensator-Anschlussbereich 205 an die Poly-Silizium-Schicht 102, die als innere Elektrode des Graben-Kondensators 1 dient, angeschlossen. Der Kanal 203 ist durch eine Gate-Dielektrikumsschicht 206 von der Wortleitung 7 abgetrennt.

Im oberen Bereich des Grabens 101 ist an das Speicher-Dielektrikum 104 angrenzend eine Isolationsschicht 106 um das Poly-Silizium 102 herum ausgebildet. Die Isolationsschicht 106 verhindert einen Leckstrom zwischen dem Kondensatoranschlusses 205 und der vergrabenen Platte 103, die die äußere Elektrode des Graben-Kondensators 1 bildet. Ein solcher Leckstrom würde die Haltezeit der Ladungen im Graben-Kondensator wesentlich verkürzen und damit in ungewünschter Weise die erforderliche Refresh-Frequenz der DRAM-Zelle erhöhen.

Im Silizium-Substrat 100 ist weiterhin eine n-dotierte Platte 107 vorgesehen, die als Verbindung der vergrabenen Platte 103 mit den vergrabenen Platten der weiteren DRAM-Speicherzellen dient und mit einem Anschluss von oben gebiast wird. Zur Isolation zwischen den DRAM-Zellen ist ein Isolationsgraben 108 (STI-Isolation) ausgebildet. Die Gate-Elektrode bzw. die die Wortleitung 7 ist von der Bitleitung 6 und dem Kontakt 204 zum ersten Diffusionsbereich 201 weiterhin durch eine Oxid-Schicht 208 isoliert.

Durch die Vergrößerung der Elektrodenoberflächen mit Hilfe der HSG-Silizium-Schicht 105 zwischen dem Speicher-Dielektrikum 104 und der vergrabenen Platte 103, die als äußere Elektrode des Graben-Kondensators 1 dient, wird die Kondensator-Kapazität wesentlich erhöht. Als zusätzliche Maßnahme ist es möglich, den unteren Bereich des Grabens 101 im Bereich der vergrabenen Platte 103 aufzuweiten und so für eine weitere Vergrößerung der Elektrodenoberfläche zu sorgen. Wichtig bei der HSG-Silizium-Schichtenbildung ist insbesondere, dass diese Schicht nur im Bereich des Grabens ausgebildet wird, jedoch nicht im Bereich des Isolationskragens, der durch die Isolationsschicht 106 gebildet ist, um eine unzuverlässige Verengung dieses oberen Grabenabschnitts zu verhindern und darüber hinaus zu gewährleisten, dass keine ungewünschten Leckstrompfade zwischen den Elektroden des Graben-Kondensators auftreten.

Zur Ausbildung einer HSG-Silizium-Schicht in einem Graben-Kondensator können dabei verschiedene Techniken angewendet werden, wobei allen Verfahren gemeinsam ist, dass in einem zentralen Schritt des Gesamtprozesses Silizium-Keime gebildet werden, die dann unter geeigneten Prozessbedingungen zu Silizium-Körnern mit einem Durchmesser von ca. 10 bis 100 nm anwachsen. Ein mögliches Verfahren zur Ausbildung der HSG-Silizium-Schicht besteht darin, Silizium bei der Übergangstemperatur vom amorphen zum poly-kristallinen Silizium abzuscheiden, wodurch sich eine HSG-Silizium-Schicht mit Silizium-Körnern bildet. Alternativ kann auch amorphes, d. h. nicht aufgerauhtes Silizium bei einer Temperatur deutlich unterhalb der Übergangstemperatur vom amorphen zum poly-kristallinen Silizium abgeschieden werden, um anschließend durch einen Heizschritt bei einer Temperatur oberhalb der Übergangstemperatur die zunächst glatte amorphe Silizium-Schicht in eine körnige HSG-Silizium-Schicht umzuwandeln. Weiterhin eignet sich ein Bekeimungsschritt dazu, die Umwandlung der amorphen Silizium-Schicht in HSG-Silizium zu bewerkstelligen. Ein nachfolgender Temperschritt ist optional. Bei dieser Technik besteht die Möglichkeit, eine unstrukturierte HSG-Silizium-Erzeugung oder aber eine ortsselektive HSG-Silizium-Erzeugung durchzuführen.

Beim unstrukturierten, d. h. nicht ortsselektiven HSG-Verfahren erfolgt nach dem Abscheiden des amorphen Siliziums ein Bekeimen dieser Schicht bei der Übergangstemperatur vom amorphen zum poly-kristallinen Silizium, wodurch Silizium-Kristallkeime aus dem amorphen Silizium entstehen. Gegebenenfalls wird dann diese bekeimte Silizium-Schicht nachgeheizt, um vergrößerte HSG-Silizium-Körner zu erzeugen. Bei der ortsselektive HSG-Silizium-Erzeugung wird die abgeschiedene amorphe Silizium-Schicht zuerst durch ein nass- oder trockenchemisches Verfahren strukturiert, um dann anschließend bei der Übergangstemperatur bekeimt zu werden, so dass Silizium-Kristallkeime entstehen. Die Prozessparameter zur Bekeimung des Siliziums werden dabei so gewählt, dass sich Kristallkeime nur auf einer Silizium-Unterlage bilden, nicht jedoch z. B. auf Silizium-Oxid oder Silizium-Nitrid. Nach dem Bekeimen der Silizium-Schicht kann dann gegebenenfalls zum Vergrößern der HSG-Körner nachgeheizt werden, so dass die Silizium-Kristallkeime durch Einbau von unverbrauchtem amorphem Silizium anwachsen.

Gemäß einem weiteren Verfahren besteht auch die Möglichkeit, die HSG-Silizium-Körner durch direkte Nukleation von polykristallinem Silizium bei einer Temperatur weit oberhalb der Übergangstemperatur vom amorphen zum polykristallinen Silizium zu erzeugen, wobei ein Inselwachstum erfolgt.

Entscheidend bei der Erzeugung der HSG-Silizium-Schicht auf der Elektrodenoberfläche des Graben-Kondensators ist, dass sichergestellt wird, dass sich die Silizium-Körner nur im Bereich dieser Elektrodenoberfläche, d. h. im unteren Bereich des Grabens im Graben-Kondensators ausbilden. Deshalb werden bei einer nicht ortsselektiven HSG-Silizium-Schicht-Erzeugung, bei der die Silizium-Körner sich auf der gesamten Grabenoberfläche festsetzen, die Silizium-Körner im oberen Bereich des Grabens, der nicht als Speicherbereich dient, nachträglich entfernt oder durch geeignete Verfahren so verändert, dass sich die Silizium-Körner wieder zurückbilden. Zum Entfernen bzw. Zurückbilden der Silizium-Körner wird der untere Bereich des Grabens mit den auf der Oberfläche haftenden HSG-Silizium-Körnern mit Hilfe einer Maskierungsschicht, z. B. einer Fotolackschicht oder einer Poly-Silizium-Schicht, abgedeckt, um eine Beschädigung zu verhindern. Bei der ortsselektiven HSG-Erzeugung auf der Grundlage einer amorphen Silizium-Schicht erfolgt die Strukturierung dagegen vor der HSG-Silizium-Erzeugung.

Im Folgenden werden verschiedene erfindungsgemäße Verfahren zur Herstellung eines Graben-Kondensators mit einer HSG-Silizium-Schicht dargestellt, wobei sich diese Verfahren durch einfache Prozessfolgen, die sich in die bekannten Standard-DRAM-Prozesse integrieren lassen, auszeichnen. Darüber hinaus gewährleisten alle dargestellten Verfahren zur Ausbildung der HSG-Silizium-Schicht im Graben-Kondensator insbesondere auch ein zuverlässiges Entfernen von HSG-Silizium-Körnern im Bereich des Isolationskragens bzw. sorgen für ein zuverlässiges Verhindern der Entstehung solcher Körner in diesem Bereich. Bei den nachfolgend erläuterten Verfahren wird danach unterschieden, ob die Kragenisolation des Graben-Kondensators vor oder nach der HSG-Silizium-Schicht-Erzeugung durchgeführt wird. Weiterhin werden sowohl Verfahren vorgestellt, bei denen die HSG-Silizium-Erzeugung ortsselektiv durchgeführt wird, als auch Verfahren, bei denen die HSG-Silizium-Erzeugung nicht ortsselektiv erfolgt. Alle dargestellten Verfahren werden dabei so ausgeführt, dass die HSG-Erzeugung durch ein Bekeimen einer amorphen Silizium-Schicht erfolgt. Alternativ besteht jedoch auch die Möglichkeit alle anderen oben erläuterten HSG-Erzeugungsverfahren zur Vergrößerung der Elektrodenoberfläche bei Graben-Kondensatoren einzusetzen.

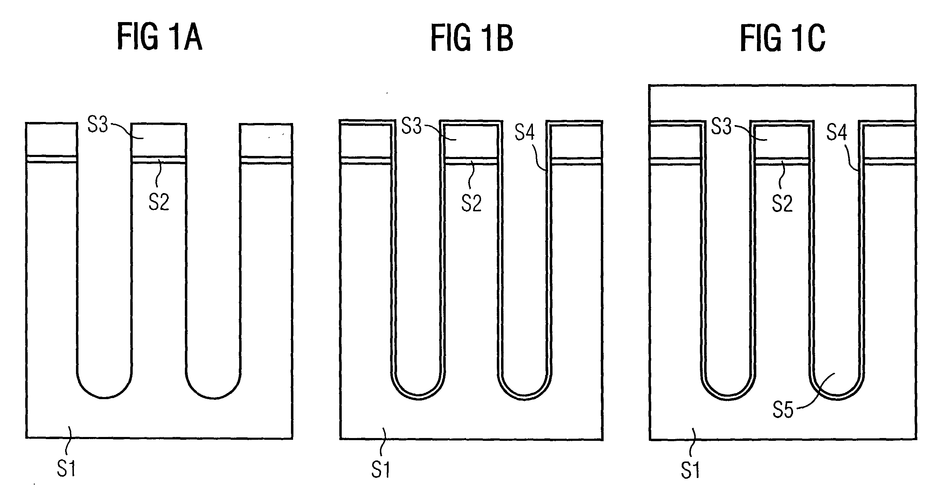

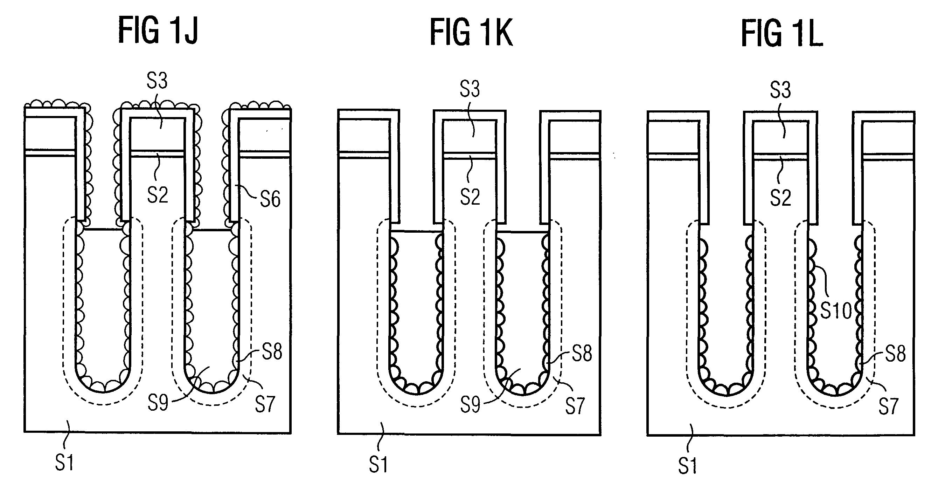

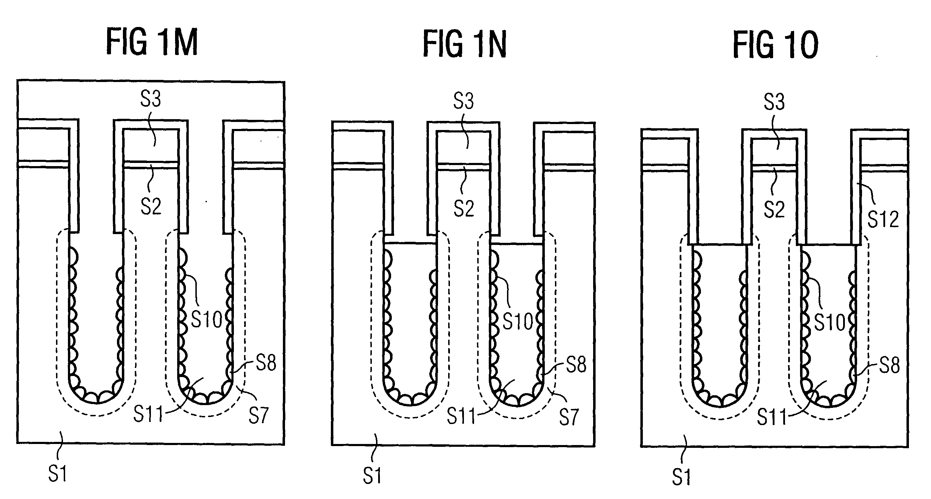

Figuren 1A bis 1M zeigen ein erstes Verfahren zur Erzeugung eines Graben-Kondensators mit einer HSG-Silizium-Schicht, bei dem die HSG-Abscheidung nicht selektiv erfolgt und die Isolationskragenschicht im oberen Grabenbereich nach der HSG-Silizium-Erzeugung ausgeführt ist.

Wie in Figur 1A dargestellt ist, werden mit einem ersten Prozessschritt Gräben für die Graben-Kondensatoren in ein p⁻-dotierte Silizium-Substrat S1 geätzt. Hierzu werden nacheinander eine Oxid-Schicht S2 und eine Nitrid-Schicht S3 auf der Halbleiteroberfläche erzeugt. Anschließend werden mit Hilfe einer zusätzlichen Hartmaske die Bereiche der Graben-Kondensatoren definiert und dann durch eine anisotrope Ätzung die Gräben mit einer Tiefe von ca. 1 bis 10µm erzeugt.

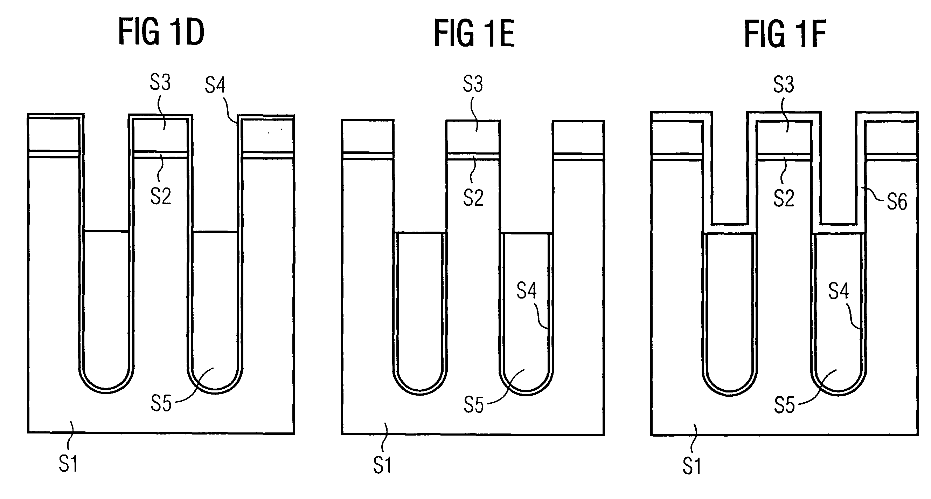

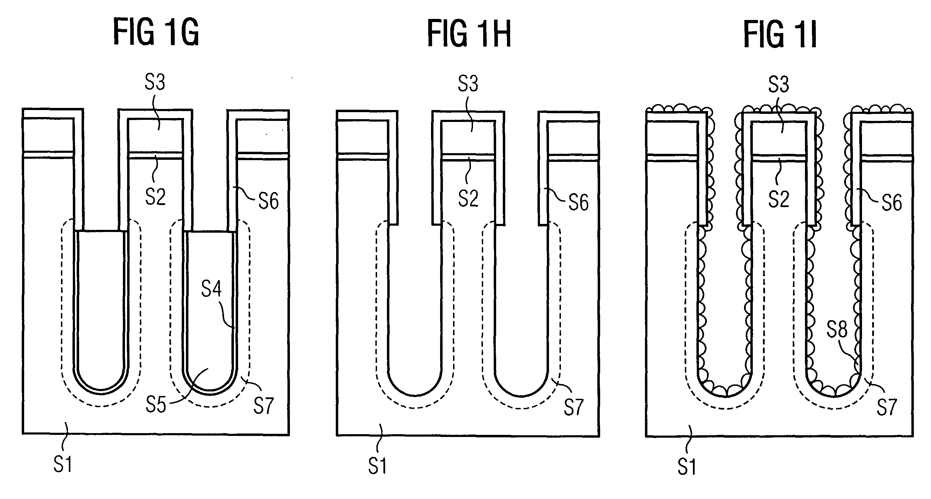

Nach der Grabenätzung erfolgt die Ausbildung einer n⁺-dotierten vergrabenen Platte. Hierbei wird zuerst, wie in Figur 1B gezeigt ist, eine Arsenglas (ASG)-Schicht S4 abgeschieden und anschließend, wie in Figur 1C dargestellt ist, werden die Gräben mit Poly-Silizium S5 aufgefüllt. Diese Poly-Silizium-Schicht S5 wird dann, wie in Figur 1D gezeigt ist, so weit zurückgeätzt, dass die Poly-Silizium-Füllung nur noch im unteren Bereich des Grabens, der als Speicher-Kondensator dient, verbleibt. Anschließend wird, wie in Figur 1E dargestellt ist, das Arsenglas S4 oberhalb der Poly-Silizium-Füllung S5 entfernt. Dann wird eine dünne Nitrid-Schicht S6 zum Verhindern eines Ausdiffundierens von Arsen aus der Arsenglasschicht S4 auf der Scheibenoberfläche abgeschieden. Figur 1F zeigt einen Querschnitt durch die Silizium-Scheibe nach diesem Prozessschritt. Durch Ausheizen wird dann Arsen aus der Arsenglasschicht S4 in das Silizium-Substrat S1 ausdiffundiert, so dass sich im unteren Bereich der Gräben eine n⁺-dotierte Schicht S7 in Form einer vergrabenen Platte ausbildet, wie dies in Figur 1G gezeigt ist.

Es folgt nun eine anisotrope Nitridätzung, um die Nitrid-Schicht S6 von der Poly-Silizium-Oberfläche S5 zu entfernen. Zur Erzeugung der HSG-Silizium-Schicht wird dann in einer Prozessfolge zuerst das restliche Poly-Silizium S5 aus den Gräben wieder entfernt, wie dies in Figur 1H gezeigt ist, und anschließend eine HSG-Silizium-Schicht S8 auf der gesamten Scheibenoberfläche erzeugt, wobei im wesentlichen alle vorgenannten Verfahren zur HSG-Erzeugung eingesetzt werden können. Ein Querschnitt durch die Silizium-Scheibe mit der HSG-Schicht ist in Figur 1I dargestellt.

Um eine Dotierung der HSG-Schicht mit den Silizium-Körnern zu gewährleisten, kann nun durch einen Ausheizschritt ein Rückdiffundieren von Arsen aus der vergrabenen Platte S7 in die HSG-Schicht S8 erfolgen. Ein solcher Heizschritt kann auch zu einem späteren Prozesszeitpunkt durchgeführt werden.

Alternativ besteht auch die Möglichkeit, die HSG-Schicht bereits während des Erzeugungsvorgangs zu dotieren oder nach der HSG-Schichterzeugung ein Nachdotieren, z. B. durch eine Gasphasendotierung mit Arsen, auszuführen.

Um die HSG-Schicht S8 aus dem oberen Grabenbereich, der nicht zur Ausbildung der Speicherelektroden dient, zu entfernen, wird, wie in Figur 1J gezeigt ist, eine Fotolack-Schicht S9 auf der Silizium-Scheibe aufgebracht, die anschließend so zurückgeätzt wird, dass die Lackfüllung S9 nur im unteren Bereich der Gräben im Bereich der vergrabenen Schicht S7 verbleibt. Dann wird mit Hilfe einer Poly-Silizium-Ätzung, wobei vorzugsweise ein Trockenätzverfahren eingesetzt wird, die HSG-Schicht S8 im nicht durch die Lackfüllung S9 maskierten Bereich entfernt. Ein Querschnitt durch die Silizium-Scheibe nach diesem Prozessschritt ist in Figur 1K gezeigt.

In einer weiteren Prozessfolge wird dann die Lackfüllung S9 wieder vollständig aus den Gräben entfernt und eine nasschemische Reinigung der Grabenoberfläche durchgeführt. Anschließend wird auf der Scheibenoberfläche das Speicher-Dielektrikum vorzugsweise als ON-(Oxid-Nitrid)-Schicht S10 abgeschieden, wie dies in Figur 1L gezeigt ist. Nach dem Abscheiden des Speicher-Dielektrikums S10 werden die Gräben mit einer n⁺-dotierten Poly-Silizium S11 aufgefüllt, wie dies in Figur 1M gezeigt ist, das anschließend wieder, wie in Figur 1N dargestellt ist, bis zur Unterkante der Nitrid-Schicht S6, die mit dem oberen Ende der vergrabenen Platte S7 zusammenfällt, zurückgeätzt wird. In einem weiteren Ätzschritt wird dann die durch die Poly-Silizium-Füllung S11 nicht maskierte Dielektrikumsschicht S10 so wie die darunterliegende Nitrid-Schicht S6 weggeätzt, um anschließend an den Seitenwänden des oberen Grabenbereichs eine Oxid-Schicht S12 zu erzeugen, die als Grabenisolationsschicht zum Verhindern von Leckpfaden zwischen der äußeren Elektrode und Drain/Buried-Strap-Bereichen des Graben-Kondensators dient.

Durch das dargestellte Verfahren wird auf einfache Weise eine HSG-Schicht zur Oberflächenvergrößerung der Elektroden im Graben-Kondensator erzeugt und zusätzlich gewährleistet, dass keine Silizium-Körner im oberen Grabenbereich zurückbleiben, die zu ungewünschten Leckströme führen würden. Nach dem in Figur 10 gezeigten Prozessschritt folgt ein Poly-Silizium-Fill-Prozess. In weiteren Prozessschritten werden dann die Auswahl-Transistoren erzeugt.

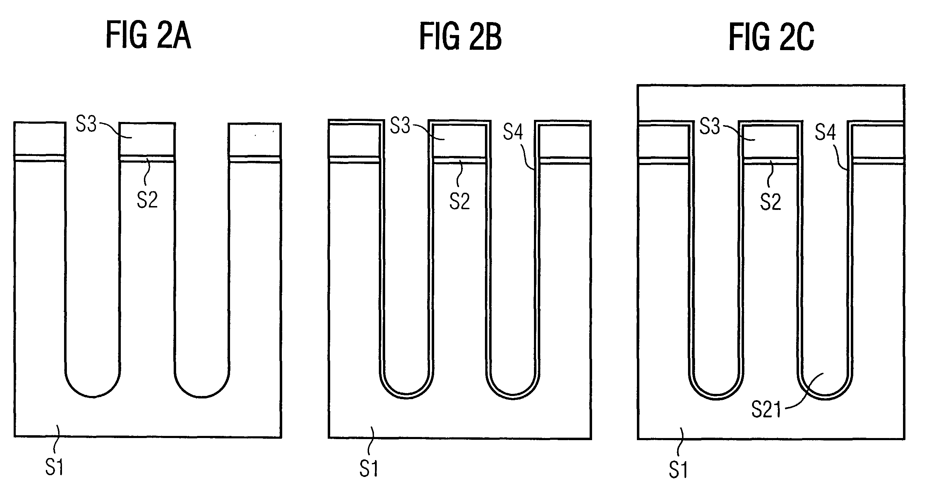

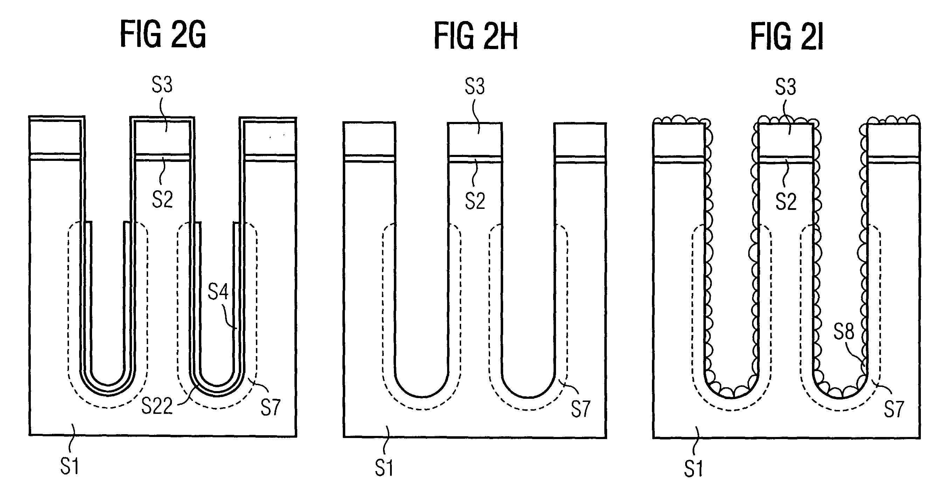

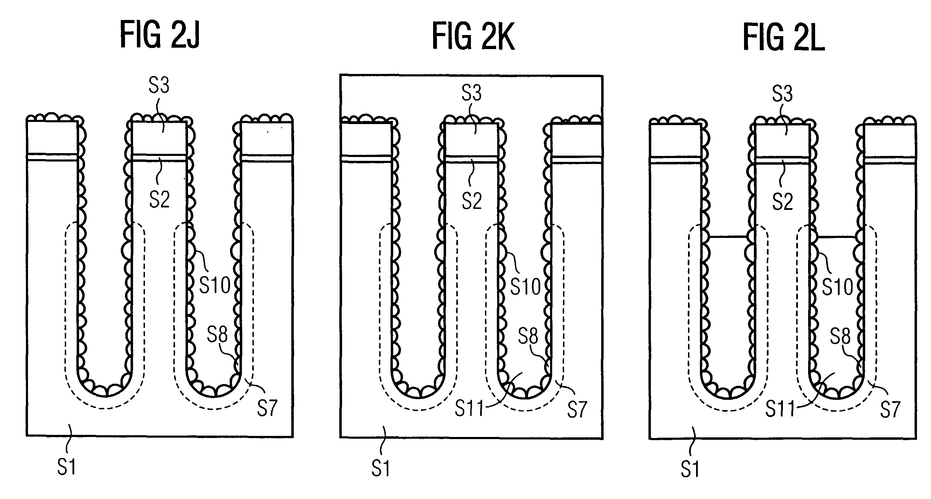

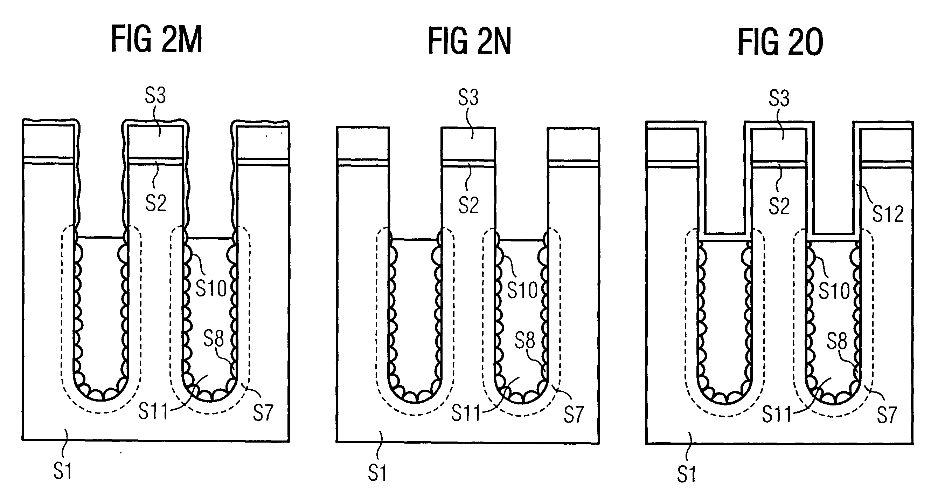

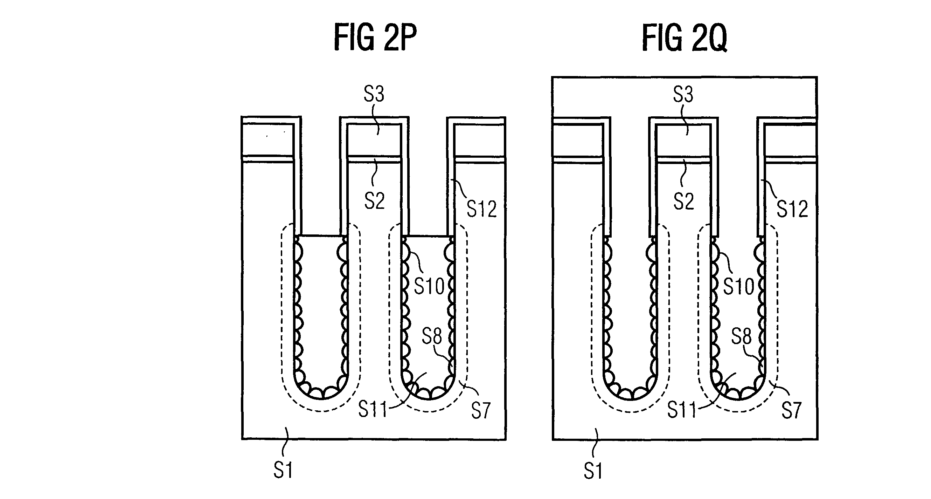

In den Figuren 2A bis 2Q ist ein zweites erfindungsgemäßes Verfahren zur Herstellung einer HSG-Silizium-Schicht dargestellt, bei der ähnlich wie bei dem ersten Verfahren eine nicht selektive HSG-Abscheidung vor der Isolationskragenbildung durchgeführt wird.

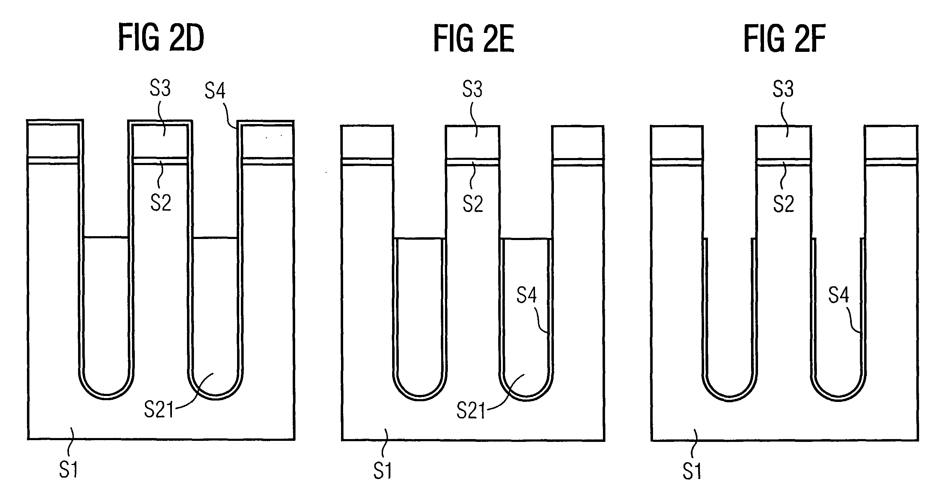

Nach dem in Figur 2A gezeigten Ätzen der Gräben in das Silizium-Substrat S1, bei dem die Gräben über einen Lithographieschritt mit Hilfe einer Hartmaske in die Oxid-Schicht S2, die Nitrid-Schicht S3 und in das Silizium-Substrat S1 hineingeätzt werden, wird anschließend, wie in Figur 2B gezeigt ist, die Arsenglas-Schicht S4 abgeschieden. Dann werden, wie in Figur 2C dargestellt ist, die Gräben mit einer Lackschicht S21 aufgefüllt, die anschließend, wie in Figur 2D dargestellt ist, zurückgeätzt wird, dass nur der untere Bereich der Arsenglas-Schicht S4 von der Lackschicht S21 abgedeckt bleibt. Nach dem Entfernen der Arsenglas-Schicht S4 im freigelegten oberen Grabenbereich, wie in Figur 2E dargestellt ist, wird wie in Figur 2F gezeigt ist, die Lackschicht S21 wieder vollständig entfernt und dann eine Oxid-Schicht S22 auf der Scheibenoberfläche, wie in Figur 2G dargestellt ist, abgeschieden. Diese Oxid-Schicht S22 dient dazu, ein Ausdiffundieren des Arsens aus der Arsenglas-Schicht S4 zu verhindern.

Dann wird durch Ausheizen das Arsen aus der Arsenglas-Schicht S4 in das Silizium-Substrat S1 ausgetrieben, so dass die n⁺-dotierte vergrabene Platte S7 entsteht. Anschließend wird, wie in Figur 2H dargestellt ist, die Oxid-Schicht S22 und das verbleibende Arsenglas S4 wieder vollständig entfernt, um, wie in Figur 1I dargestellt ist, die HSG-Silizium-Schicht S8 zu erzeugen. In einer nächsten Prozessfolge wird, wie in Figur 2J und Figur 2K gezeigt ist, zuerst das Speicher-Dielektrikum S10 abgeschieden, um anschließend die Gräben vollständig mit n⁺-dotiertem Poly-Silizium S11 aufzufüllen. Die Poly-Silizium-Schicht S11 wird, wie in Figur 2L gezeigt ist, dann bis zur vorgesehenen Unterkante der Kragenisolationsschicht, die im wesentlichen mit der Oberkante der vergrabenen Platte S7 zusammenfällt, zurückgeätzt.

Um anschließend die HSG-Silizium-Schicht im freigelegten Grabenbereich, der nicht durch die Poly-Silizium-Füllung S11 geschützt ist, zu entfernen, wird in einem ersten Schritt durch Ausheizen ein Planarisieren der HSG-Silizium-Schicht S8 vorgenommen, bei der sich die Silizium-Körner wieder zurückbilden und so eine relativ glatte Oberfläche entsteht. Dieses planarisierte HSG-Silizium lässt sich, wie in Figur 2N gezeigt ist, dann durch eine nass- oder trockenchemische Ätzung einfach und leicht entfernen. Anschließend wird dann, wie in Figur 20 gezeigt ist, die Oxid-Schicht S12 abgeschieden, die als Kragenisolationsschicht dient. Diese Oxid-Schicht S12 wird, wie in Figur 2P dargestellt ist, durch eine Ätzschritt so strukturiert, dass die Oxid-Schicht S12 nur an den Seitenwänden im oberen Grabenbereich stehen bleibt. Anschließend werden dann, wie in Figur 2Q dargestellt ist, die Gräben wieder vollständig mit n⁺-dotiertem Poly-Silizium S11 aufgefüllt und in darauffolgenden Schritten dann die Auswahl-Transistoren der DRAMs hergestellt.

Die in Figuren 2A bis 2Q gezeigte Technik zur HSG-Bildung auf der Elektrodenoberfläche der Graben-Kondensatoren sorgt zuverlässig dafür, dass nur im Bereich der Elektrodenoberflächen HSG-Silizium verbleibt. Durch das Planarisieren der zu entfernenden HSG-Schicht im oberen Grabenbereich der Graben-Kondensatoren wird nämlich gewährleistet, dass sich diese ungewünschte HSG-Silizium-Schicht besonders leicht abätzen lässt. Beim Planarisierungsvorgang ist entscheidend, dass der untere Grabenbereich mit der HSG-Schicht, die zur Oberflächenvergrößerung der Elektroden dient, dabei zuverlässig von einer temperaturstabilen Schicht geschützt wird, um eine Beschädigung zu verhindern. Das Planarisieren der Silizium-Körner erfolgt vorzugsweise mit Hilfe eines Hochtemperaturschrittes bei einer Temperatur von ca. 1000° in einer vordefinierten Atmosphäre bei einem Druck von ca. 70 Torr. Statt einem Planarisieren der HSG-Silizium-Schicht kann auch alternativ ein Oxidieren vorgenommen werden, um die HSG-Schicht in SiO₂ umzuwandeln und dann leicht entfernen zu können.

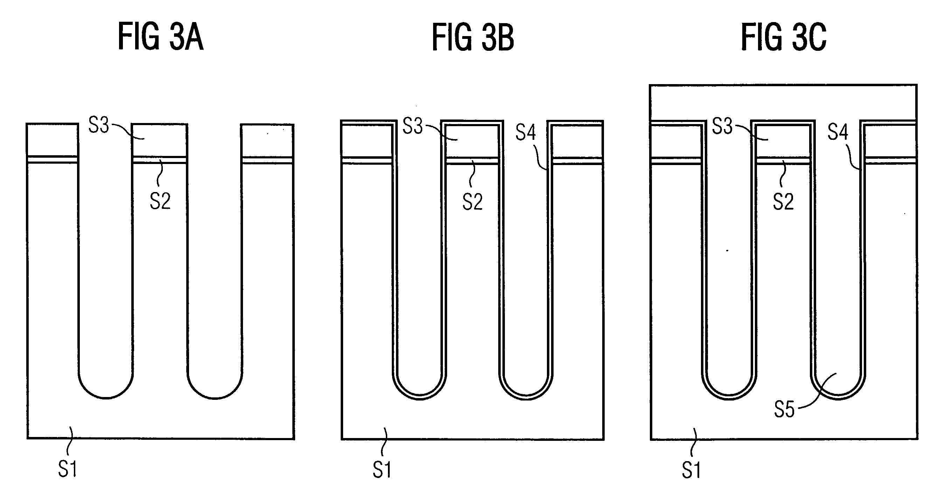

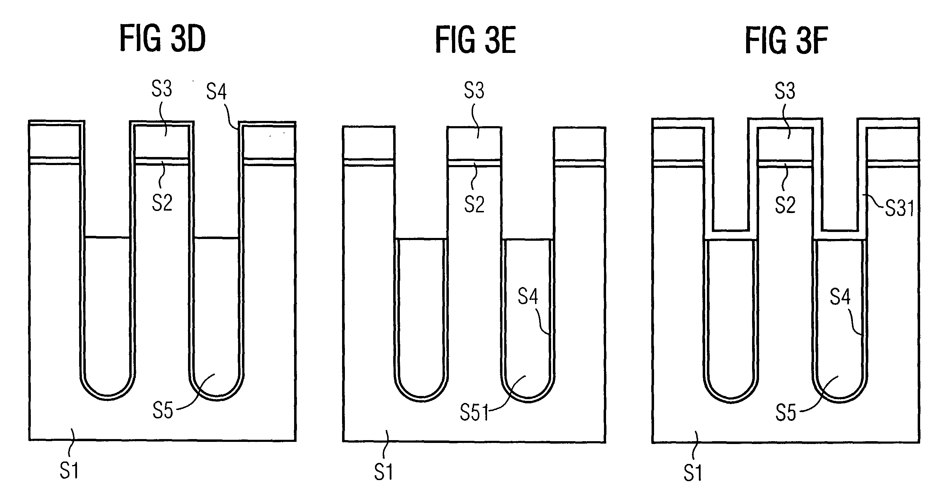

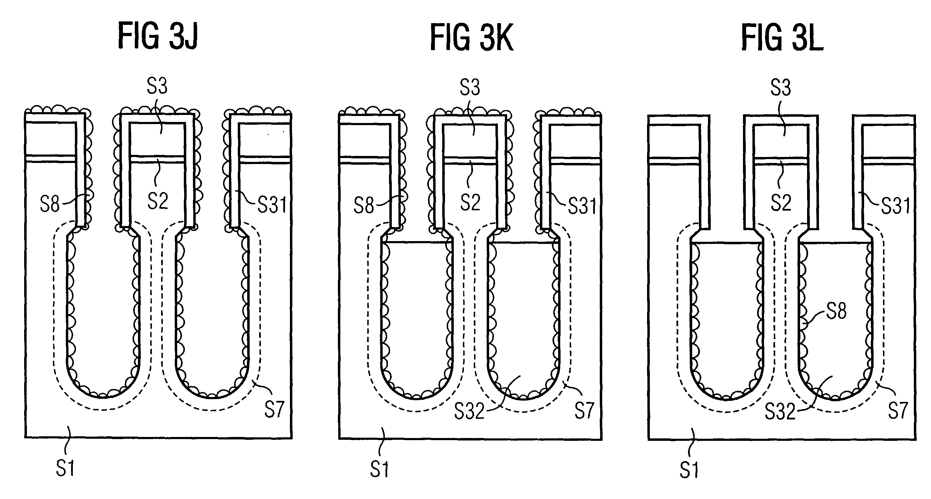

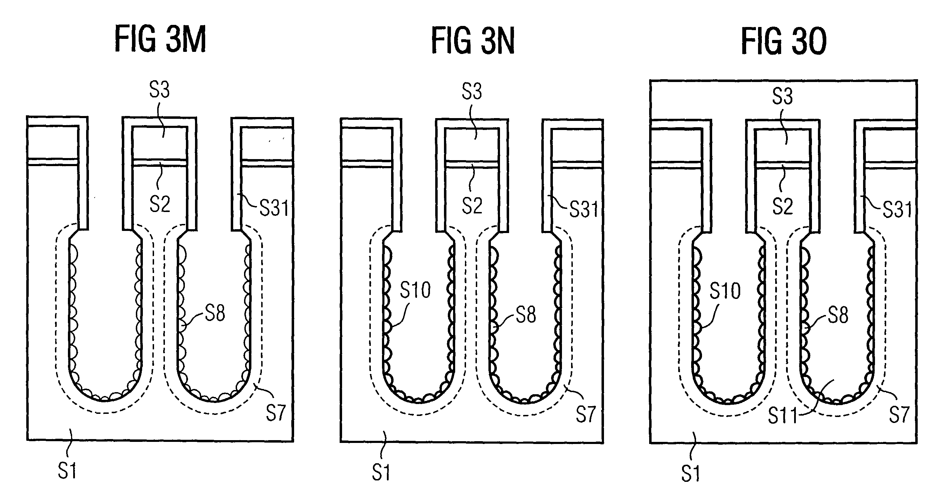

Figuren 3A bis 30 zeigen ein weiteres mögliches Verfahren zur Elektrodenoberflächenvergrößerung in einem Graben-Kondensator mit einer HSG-Schicht, wobei hier zusätzlich eine Vergrößerung der Elektrodenoberfläche durch eine Grabenausweitung im unteren Grabenbereich erfolgt und darüber hinaus vor der HSG-Silizium-Bildung die Isolation des Kragenbereiches durchgeführt wird.

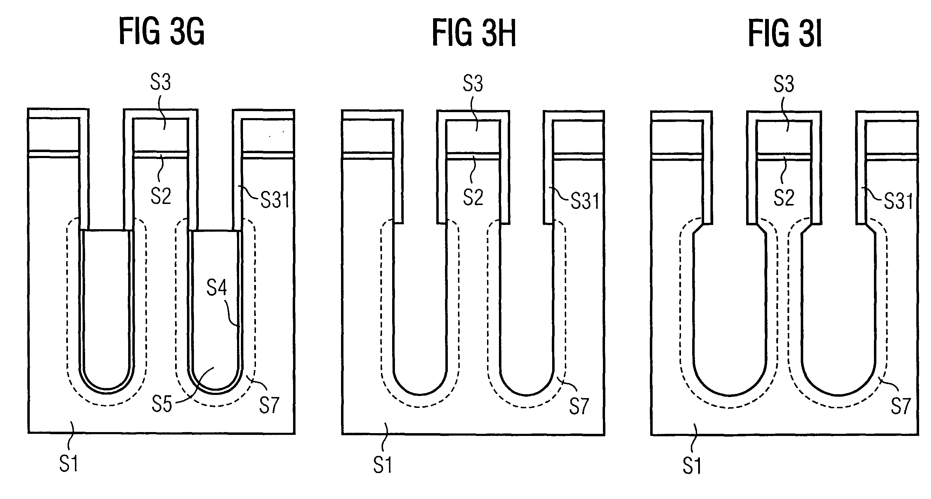

Die in den Figuren 3A bis 3E gezeigte Prozessfolge entspricht dabei den in den Figuren 1A bis 1E gezeigten Prozessschritten. Nach dem Entfernen der Arsenglas-Schicht S4 im oberen Grabenbereich vorzugsweise durch nasschemisches Ätzen wird zur Erzeugung des Isolationskragens vor der HSG-Schicht-Erzeugung aber eine Oxid-Schicht S31 auf der Scheibenoberfläche abgeschieden, wie dies in Figur 3F gezeigt ist. Anschließend wird durch einen Hochtemperaturschritt das Arsen aus der Arsenglas-Schicht S4 in das umliegende Silizium-Substrat S1 ausgetrieben, um hier die n⁺-dotierte vergrabene Platte S7 zu erzeugen. Dann wird die Oxid-Schicht S31, die beim Ausheizschritt ein Ausdiffundieren des Arsens aus der Arsenglas-Schicht S4 verhindert, so zurückgeätzt, dass sie nur als Spacer-Struktur an den Seitenwänden im oberen Grabenbereich zurück bleibt. Ein Querschnitt durch die Halbleiterstruktur nach diesem Prozessschritt ist in Figur 3G dargestellt.

Anschließend wird dann die Poly-Silizium-Schicht S5, die als Maskierung des unteren Grabenbereiches zur Ausbildung der Kragenoxid-Schicht S31 gedient hat, so wie das verbleibende Arsenglas S4 wieder entfernt, wie es in Figur 3H dargestellt ist. Dann wird, wie in Figur 3I gezeigt ist, der untere Grabenbereich zur Oberflächenvergrößerung der Elektroden durch einen Ätzvorgang vergrößert. In einer nächsten Prozessfolge wird dann über die gesamte Oberfläche der Scheibe eine HSG-Silizium-Schicht S8 erzeugt, wie dies in Figur 3J dargestellt ist.

Diese HSG-Silizium-Schicht S8 wird, wie in Figur 3K gezeigt ist, im unteren Grabenbereich unterhalb der Kragenoxid-Schicht S31 maskiert, wobei die Gräben zuerst mit einer Fotolack-Schicht S32 vollständig aufgefüllt werden, die dann bis zur Unterkante der Kragenoxid-Schicht S31 zurückgeätzt wird. Anschließend wird dann die HSG-Silizium-Schicht S8 im nicht durch die Lackfüllung S32 markierten Bereich wieder entfernt. Hier kann auch die im Zusammenhang mit Figuren 2A bis 2Q dargestellte Technik des Planarisierens und anschließenden Entfernens der HSG-Schicht eingesetzt werden. Allerdings muss dann anstatt der Lackfüllung z. B. eine Poly-Silizium-Füllung verwendet werden. Zudem muss gegebenenfalls das HSG-Silizium zuvor oberflächlich passiviert werden.

Nach diesem Prozessschritt, der in Figur 3L gezeigt ist, wird dann in einer Prozessfolge, die in Figur 3M bis 30 dargestellt ist, die Lackfüllung S32 wieder aus den Gräben entfernt, anschließend die Scheibenoberfläche insbesondere auch im Bereich des HSG-Siliziums S8 gereinigt, um dann eine NO-Abscheidung S10 zur Erzeugung des Speicher-Dielektrikums vorzunehmen. Zur Erzeugung der inneren Elektrode bei Graben-Kondensatoren werden die Gräben weiterhin mit n⁺-dotiertem Poly-Silizium S11 aufgefüllt.

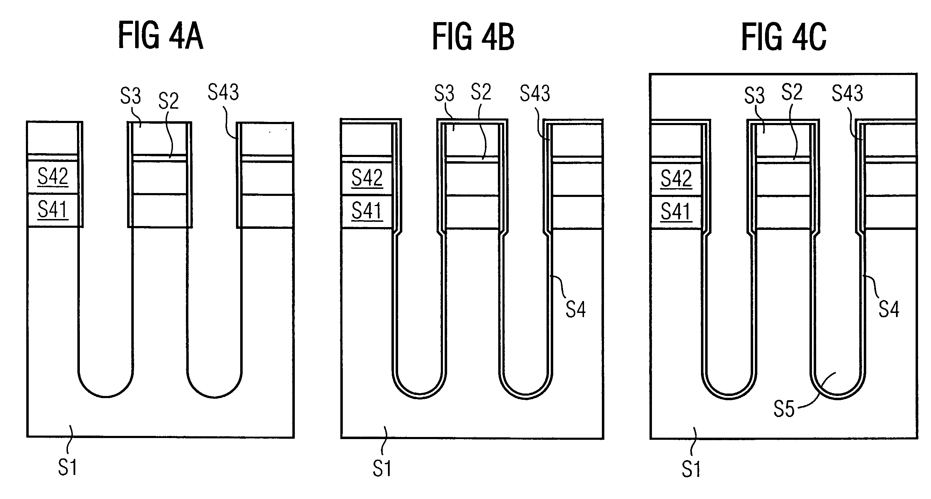

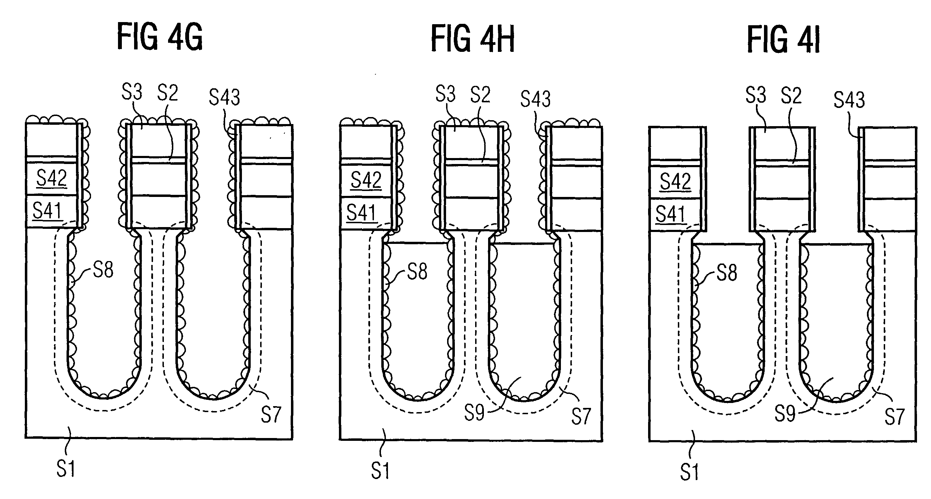

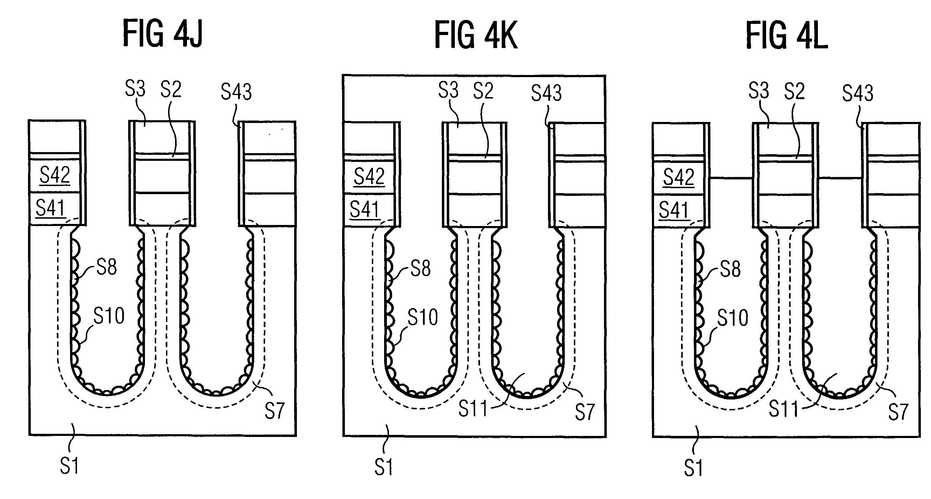

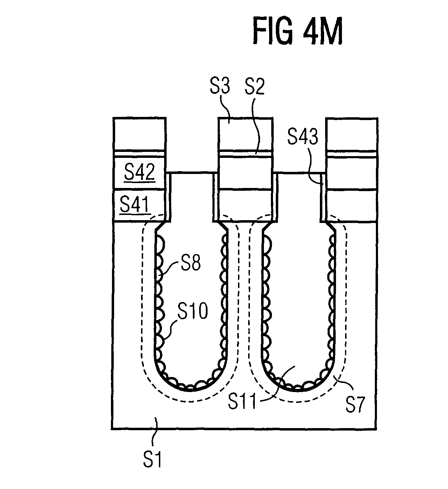

Figur 4A bis 40 zeigt eine vierte erfindungsgemäße Prozessabfolge, bei der ein Graben-Kondensator mit einer HSG-Silizium-Schicht auf einem SOI (Silicon-On-Insulator)-Substrat in nicht selektiver Abscheidetechnik hergestellt wird.

Wie Figur 4A zeigt, werden die Gräben in eine Scheibenoberfläche geätzt, bei der auf dem Silizium-Substrat S1 eine Schichtenfolge aus einer Oxid-Schicht S41 und einer Silizium-Schicht S42 angeordnet ist. Wiederum bedecken eine dünne Oxid-Schicht S2 und die Nitrid-Schicht S3 die Oberfläche. Die Grabenätzung erfolgt mit Hilfe einer zusätzlichen, hier nicht abgebildeten Hartmaske. Der obere Grabenbereich in dem die Kragenisolationsschicht ausgebildet wird, ist zusätzlich durch eine dünne Nitrid-Schicht S43 geschützt.

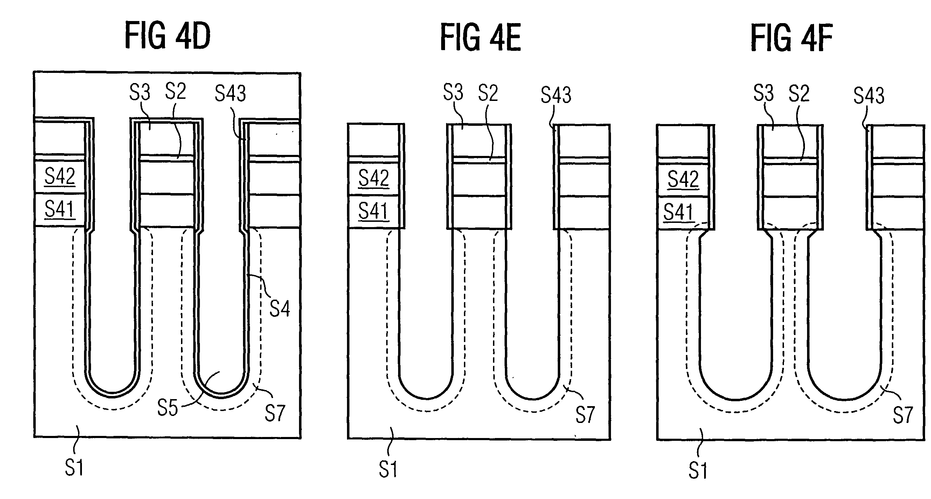

In weiteren Prozessschritten wird, wie in Figur 4B bis 4D dargestellt ist, zuerst die Arsenglas-Schicht S4 auf der Scheibenoberfläche abgeschieden und dann die Gräben mit der poly-Silizium-Schicht S5 aufgefüllt. Anschließend wird, um die vergrabenen Platte S7 auszubilden, Arsen durch einen Hochtemperaturschritt in das umliegende Silizium-Substrat S1 ausgetrieben. Als Maskierung zum Verhindern einer Arsendotierung im oberen Grabenbereiches dient dabei die dünne Nitrid-Schicht S43. Ein Querschnitt durch die Scheibenoberfläche nach diesem Prozessschritt ist in Figur 4D gezeigt.

Anschließend wird, wie in Figur 4E dargestellt ist, die Poly-Silizium-Schicht S5 wieder aus den Gräben vollständig entfernt, um dann vorzugsweise durch nasschemisches Ätzen den unteren Grabenbereich unterhalb der Nitrid-Schicht S43 auszuweiten, wie dies in Figur 4F dargestellt ist. In weiteren Prozessschritten wird die nicht selektive HSG-Silizium-Abscheidung S8 auf der gesamten Scheibenoberfläche vorgenommen, wie dies in Figur 4G dargestellt ist, um anschließend die Gräben mit der Lackschicht S9 aufzufüllen, die dann unterhalb der Kante der Oxid-Schicht S41, die den Isolationskragen definiert, zurückgeätzt wird. Die freigelegte HSG-Siliziumschicht S8 wird anschließend entfernt.

Nach dem darauffolgenden Entfernen der Lackfüllung S9 aus den Gräben wird die NO-Schicht als Speicher-Dielektrikum S10 auf der Scheibenoberfläche abgeschieden, wie dies in Figur 4J dargestellt ist, und dann die Gräben mit n⁺-dotierten PolySilizium S11, das als innere Elektrode dient, aufgefüllt. Diese Poly-Silizium-Schicht S11 wird bis unterhalb der OxidSchicht S2 und der Nitrid-Schicht S3 zurückgeätzt und anSchießend das freigelegte Speicher-Dielektrikum S10 und die darunterliegende Nitrid-Schicht S43 an den Seitenwänden des Grabens entfernt. Die Funktion des Kragenoxids aus dem vorangegangenen Ausführungsbeispiel übernimmt hier die vergrabene Oxid-Schicht S41.

Bei den bisher vorgestellten Verfahren zur Herstellung der HSG-Silizium-Schicht zur Vergrößerung der Elektrodenoberfläche im Graben-Kondensator wurde immer eine nicht selektive Abscheidetechnik eingesetzt, bei der eine nachträgliche Entfernung der HSG-Schicht im Isolationskragenbereich vorgenommen wird.

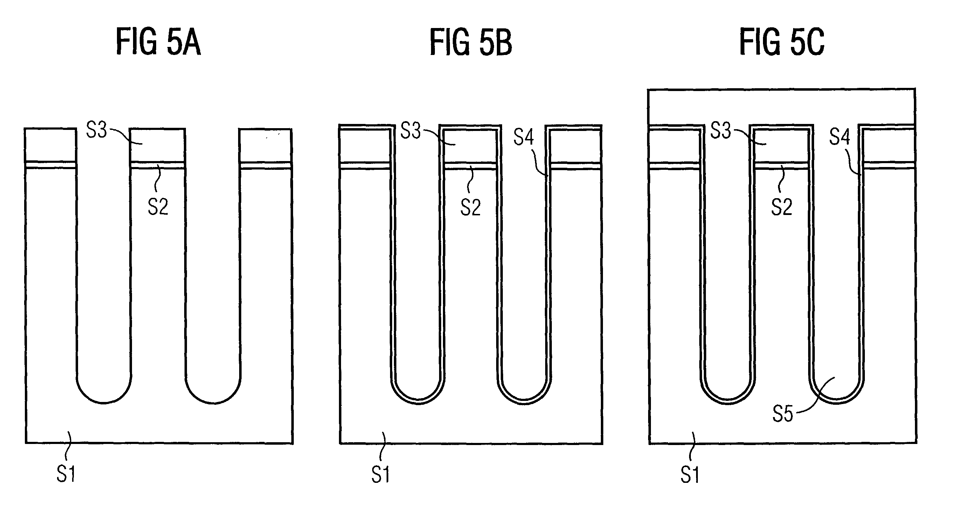

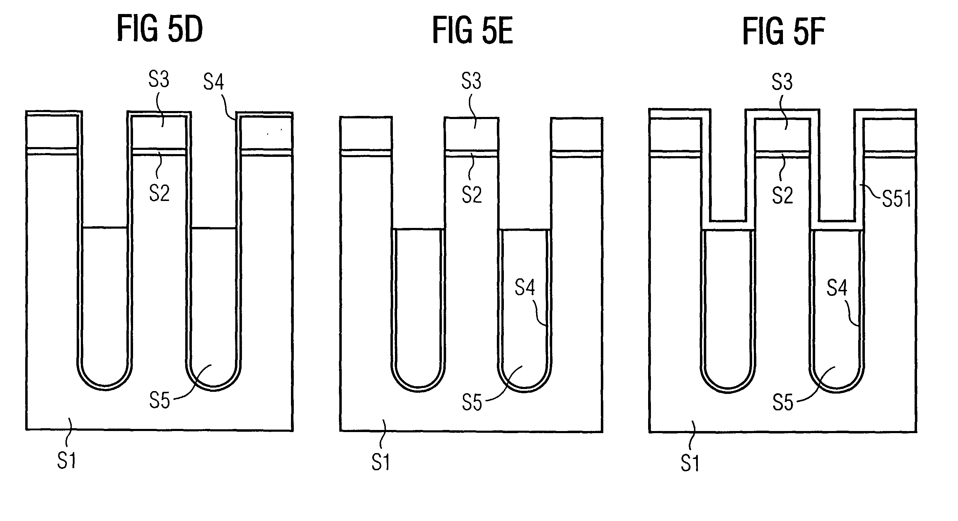

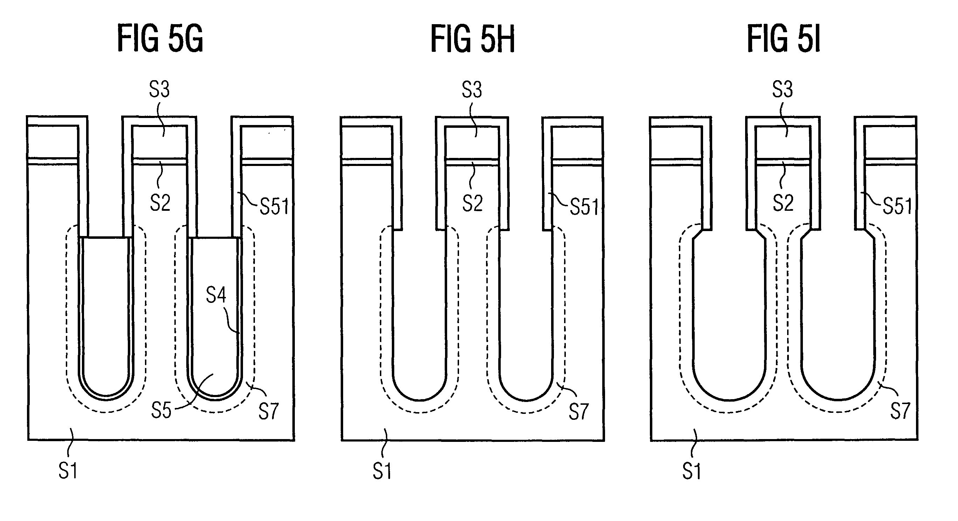

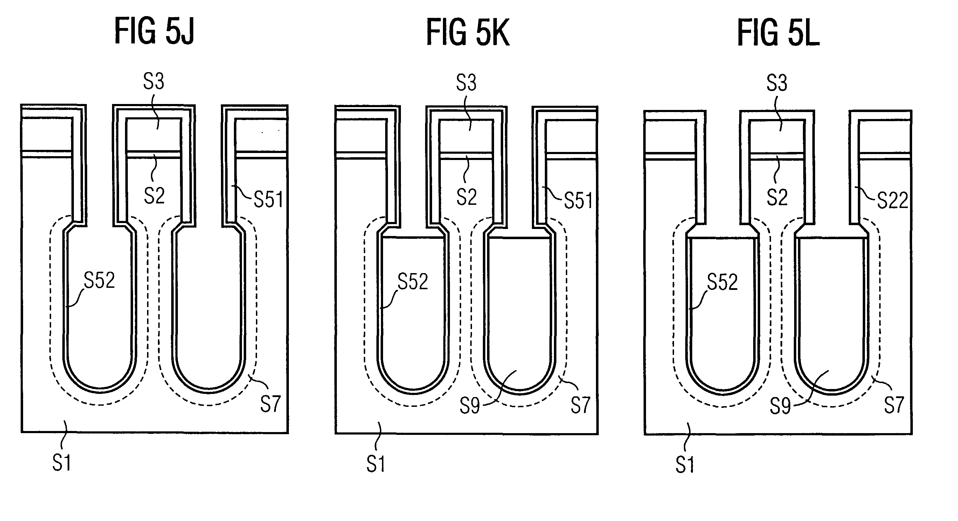

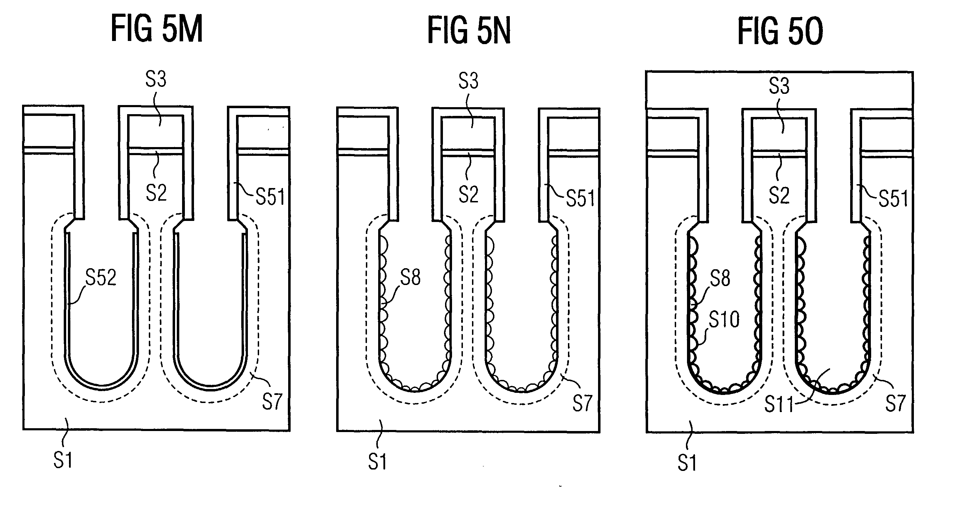

Figuren 5A bis 50 zeigen eine fünfte Ausführungsform, bei der eine ortsselektive HSG-Erzeugung im unteren Grabenbereich vorgenommen wird. Das nachstehende Verfahren lässt sich jedoch grundsätzlich auch auf alle vorgenannten Ausführungsbeispiele von Graben-Kondensatoren anwenden. Der dargestellte Prozessablauf ist wesentlich an den im Zusammenhang mit dem zweiten Ausführungsbeispiel dargestellten Prozessablauf angelehnt.

Nach der in Figur 5A gezeigten Grabenätzung erfolgt die Arsenglasabscheidung S4 und anschließend ein Auffüllen der Gräben mit der Poly-Silizium-Schicht S5. Diese Poly-Silizium-Schicht S5 wird dann aus dem oberen Bereich der Gräben, in dem die Kragenisolation ausgebildet werden soll, wieder entfernt. Anschließend wird in diesem Bereich auch das Arsenglas S4 vorzugsweise durch ein nasschemisches Ätzen weggeätzt. Diese Prozessfolge ist in Figur 5A bis 5E gezeigt.

Wie in Figur 5F und 5G dargestellt ist, wird dann eine Oxid-Schicht S51 auf der Scheibenoberfläche abgeschieden und anschließend Arsen aus der Arsenglas-Schicht S4 in das umliegende Silizium-Substrat S1 ausgetrieben, um die vergrabene Platte S7 zu bilden. Dann wird, wie in Figur 5G dargestellt ist, durch Ätzen die Oxid-Schicht S51 so strukturiert, dass diese nur an den Seitenwänden des Grabens verbleibt. Nach dem anschließenden Entfernen der restlichen Poly-Silizium-Füllung S5 in den Gräben und dem Wegätzen des verbleibenden Arsenglas-Schicht S4 wird zur Vergrößerung der Elektrodenoberfläche der untere Grabenbereich durch einen weiteren Ätzschritt aufgeweitet, wie dies in Figur 5I dargestellt ist.

Dann wird auf der gesamten Scheibenoberfläche, insbesondere auch im Grabenbereich, eine dünne amorphe Silizium-Schicht S52 abgeschieden, wie dies in Figur 5J dargestellt ist. Anschließend werden die Gräben mit der Fotolack-Schicht S9 aufgefüllt, die in einem weiteren Schritt dann bis unterhalb der Kragenoxid-Schicht S51 zurückgeätzt wird. Die Lackfüllung S9 dient zur Maskierung der amorphen Silizium-Schicht S52 im unteren Grabenbereich beim Ätzen der Kragenoxid-Schicht S51, um eine Beschädigung zu verhindern. Die amorphe Silizium-Schicht S52 wird dann im freigelegten oberen Bereich durch ein nass- oder trockenchemisches Ätzen wieder entfernt und anschließend die Lackfüllung S9 aus den Gräben herausgeätzt, so dass diese Gräben wieder komplett freigelegt sind.

Nach einem Reinigen der Scheibenoberfläche insbesondere auch im unteren Grabenbereich wird die verbliebene amorphe Siliziumfläche S52 bei der Übergangstemperatur vom amorphen zum kristallinen Silizium ortsselektiv bekeimt, so dass Silizium-Kristallkeime entstehen. Falls erforderlich, kann in einen anschließenden Temperschritt die bekeimte Silizium-Schicht noch weiter in die HSG-Silizium-Schicht S8 umgewandelt werden. Ein Querschnitt durch die Scheibenoberfläche nach diesem Prozessschritt ist in Figur 5N gezeigt. Der selektive Charakter der HSG-Bildung ist deutlich erkennbar. Nur in dem Bereich, in dem sich zuvor die amorphe Si-Schicht befand, wird HSG gebildet. In einer weiteren Prozessschrittfolge wird dann das Speicher-Dielektrikum S10 abgeschieden und das Auffüllen der Gräben mit n⁺-dotiertem Poly-Silizium S11 zur Erzeugung der innere Elektrode vorgenommen.

Mit Hilfe der vorgestellten erfindungsgemäßen Techniken zur Ausbildung von Graben-Kondensatoren in DRAM-Herstellungsprozessen ist es möglich, durch eine aufgerauhte Silizium-Oberfläche auf wenigstens einer der Kondensatoroberflächen die Kapazität des Graben-Kondensators wesentlich zu erhöhen und gleichzeitig zu gewährleisen, dass das aufgerauhte Silizium auch wirklich nur auf der Elektrodenoberfläche innerhalb des Graben-Kondensators, nicht jedoch im Isolationskragenbereich verbleibt. Die dargestellten Verfahren sind doch nicht auf einen DRAM-Herstellungsprozess beschränkt, sondern können bei allen Halbleiterbauteilen mit Graben-Kondensatoren verwendet werden.

Es liegt weiterhin im Rahmen der Erfindung über die oben genannten Ausführungsbeispiele hinaus, die angegebenen Abmessungen, Konzentrationen, Materialen und Prozesse in geeigneter Weise zu modifizieren, um den erfindungsgemäßen Graben-Kondensator mit HSG-Silizium-Schicht herzustellen. Insbesondere kann dabei auf alle bekannten Prozessabfolgen zur Ausbildung von Graben-Kondensatoren insbesondere im Rahmen von DRAM-Herstellungsprozessen zurückgegriffen werden. Weiterhin besteht die Möglichkeit, den Leitfähigkeitstyp der dotierten Gebiete in der Halbleiterstruktur komplementär auszuführen. Darüber hinaus können die angegebenen Materialen zur Ausbildung der verschiedenen Schichten durch andere in diesem Zusammenhang bekannte Materialien ersetzt werden. Insbesondere können dabei zur Ausbildung des Speicher-Schicht statt einer ON-Schicht auch andere bekannte Dielektrikas mit hoher Dielektrizitätskonstante eingesetzt werden. Weiterhin können neben den dargestellten Halbleiterschichten weitere Schichtenfolgen, z. B. zur Ausbildung von Barrieren, um ungewünschte Diffusionen zu verhindern, in die Halbleiterstruktur eingebracht werden. Außerdem können in geeigneter Weise die Selektivitäten und Maskenfolgen in den dargestellten Strukturprozessen abgeändert werden, ohne den Bereich der Erfindung zu verlassen. Anstelle des HSG-Siliziums kann beispielsweise auch HSG-SiₓGe₁₋ₓ Verwendung finden.

Die in der vorstehenden Beschreibung, den Zeichnungen und den Ansprüchen offenbarten Merkmale der Erfindung, können sowohl einzeln als auch in beliebiger Kombination für die Verwirklichung der Erfindung in ihren verschiedenen Ausgestaltungen von Bedeutung sein.

## Patentansprüche

1. Verfahren zum Herstellen eines Graben-Kondensators, insbesondere zur Verwendung in einer Halbleiter-Speicherzelle, mit den Verfahrensschritten:
Bereitstellen eines Silizium-Substrats;
Bilden eines Grabens im Silizium-Substrat;
Ausbilden einer dotierten Schicht im Silizium-Substrat in einem unteren Bereich des Grabens;
Erzeugen einer aufgerauhten Silizium-Schicht mit Silizium-Körnern, die vorzugsweise einen Durchmesser im Bereich von im wesentlichen 10 bis 100nm aufweisen, im unteren Bereich des Grabens;
Aufbringen einer dielektrischen Zwischenschicht auf der aufgerauhten Silizium-Schicht; und
Auffüllen des Grabens mit einer dotierten Schicht;
**dadurch gekennzeichnet, dass**
zum Erzeugen der aufgerauhten Silizium-Schicht eine amorphe Silizium-Schicht auf der gesamten Grabenoberfläche abgeschieden wird, dann die amorphe Silizium-Schicht durch ein Ätzverfahren so strukturiert wird, dass die amorphe Silizium-Schicht auf den unteren Grabenbereich begrenzt ist, und anschließend die amorphe Silizium-Schicht bekeimt wird, um die Silizium-Körner zu bilden.

2. Verfahren zum Herstellen eines Graben-Kondensators, insbesondere zur Verwendung in einer Halbleiter-Speicherzelle, mit den Verfahrensschritten:
Bereitstellen eines Silizium-Substrats;
Bilden eines Grabens im Silizium-Substrat;
Ausbilden einer dotierten Schicht im Silizium-Substrat in einem unteren Bereich des Grabens;
Erzeugen einer aufgerauhten Silizium-Schicht mit Silizium-Körnern, die vorzugsweise einen Durchmesser im Bereich von im wesentlichen 10 bis 100nm aufweisen, im unteren Bereich des Grabens;
Aufbringen einer dielektrischen Zwischenschicht auf der aufgerauhten Silizium-Schicht; und
Auffüllen des Grabens mit einer dotierten Schicht; **dadurch gekennzeichnet, dass** die aufgerauhte Silizium-Schicht zuerst auf der gesamten Grabenoberfläche erzeugt, anschließend der untere Bereich der aufgerauhten Silizium-Schicht im Graben maskiert, und dann die aufgerauhte Silizium-Schicht im oberen Bereich des Grabens mit Hilfe eines Ätzverfahrens wieder entfernt wird.

3. Verfahren nach Anspruch 2, **dadurch gekennzeichnet, dass** ein Planarisieren der aufgerauhten Silizium-Schicht im oberen Grabenbereich vor dem Entfernen dieser Schicht erfolgt.

4. Verfahren nach Anspruch 3, **dadurch gekennzeichnet, dass** das Planarisieren der aufgerauhten Silizium-Schicht durch einen Hochtemperaturschritt erfolgt, wobei die aufgerauhte Silizium-Schicht im unteren Grabenbereich durch eine temperaturstabile Schicht maskiert ist.

5. Verfahren nach einem der Ansprüche 2 bis 4, **dadurch gekennzeichnet, dass** zum Ausbilden der aufgerauhten Silizium-Schicht Silizium bei der Übergangstemperatur vom amorphen zum polykristallinen Silizium abgeschieden wird.

6. Verfahren nach einem der Ansprüche 1 bis 5, **dadurch gekennzeichnet, dass** zum Ausbilden der aufgerauhten Silizium-Schicht im wesentlichen glattes amorphes Silizium bei einer Temperatur deutlich unterhalb der Übergangstemperatur vom amorphen zum polykristallinem Silizium abgeschieden wird und anschließend durch einen Heizschritt bei einer Temperatur in der Nähe oder oberhalb der Übergangstemperatur die im wesentlichen glatte Silizium-Schicht in die aufgerauhte Silizium-Schicht umgewandelt wird.

7. Verfahren nach einem der Ansprüche 1 bis 6, **dadurch gekennzeichnet, dass** eine Isolationsschicht in einem oberen Bereich des Grabens vor dem Erzeugen einer aufgerauhten Silizium-Schicht ausgebildet wird.

8. Verfahren nach Anspuch 7, **dadurch gekennzeichnet, dass** die amorphe Silizium-Schicht in einem unteren Bereich des Grabens selektiv bekeimt wird, um Silizium-Körner zu bilden.

9. Verfahren nach einem der Ansprüche 1 bis 6, **dadurch gekennzeichnet, dass** eine Isolationsschicht in einem oberen Bereich des Grabens nach dem Erzeugen einer aufgerauhten Silizium-Schicht ausgebildet wird.
